# EUROPÄISCHE PATENTSCHRIFT

(11) **EP 1 966 345 B1**
(45) Veröffentlichungstag und Bekanntmachung des Hinweises auf die Patenterteilung: **22.04.2009**
(21) Anmeldenummer: 06830196.9
(22) Anmeldetag: 29.11.2006
(51) Int. Cl.: C09K 11/78, C09K 11/79, H01J 40/18

(54) **ROT EMITTIERENDER LEUCHTSTOFF UND LICHTQUELLE MIT EINEM DERARTIGEN LEUCHTSTOFF**
RED-EMITTING LUMINESCENT SUBSTANCE AND LIGHT SOURCE COMPRISING SUCH A LUMINESCENT SUBSTANCE
SUBSTANCE LUMINESCENTE EMETTRICE DE ROUGE ET SOURCE LUMINEUSE COMPRENANT UNE TELLE SUBSTANCE

(30) Priorität: 13.12.2005 DE 102005059521
(43) Veröffentlichungstag der Anmeldung: 10.09.2008
(73) Patentinhaber: Osram Gesellschaft mit beschränkter Haftung, 81543 München (DE)
(72) Erfinder: FIEDLER, Tim, 81377 München (DE); HEMPEL, Wolfram, 71397 Leutenbach (DE); JERMANN, Frank, 86343 Königsbrunn (DE)
(86) Internationale Anmeldenummer: PCT/EP2006/069067
(87) Internationale Veröffentlichungsnummer: WO 2007/068592

(56) Entgegenhaltungen:
- EP-A- 1 560 274
- WO-A-20/05030904
- WO-A-20/05031797
- US-A1- 2005 035 704
- US-B1- 6 717 353
- PUGAR E. A. ET AL: J. AM. CERAM. SOC., Bd. 71, Nr. 6, Juni 1988 (1988-06), Seiten C-288-C-291, XP002424756

## Beschreibung

### Technisches Gebiet

Die Erfindung geht aus von einem rot emittierenden Leuchtstoff und betrifft außerdem eine Lichtquelle, insbesondere LED, mit einem derartigen Leuchtstoff. Der Leuchtstoff gehört der Klasse der Oxinitridosilikate an.

### Stand der Technik

Bisher gibt es wenige technisch einsetzbare Leuchtstoffe aus der Klasse der Oxinitridosilikate, die rot emittieren und die im Spektralbereich UV, blau bis grün anregbar sind. Sie sind allerdings aufwendig herzustellen. Ein Beispiel ist das in EP-A 1 153 101 beschriebene Nitridosilikat Ca2Si5N8:Eu, das orange-rot emittiert. Dieser Leuchtstoff ermöglicht in Verbindung mit hocheffizienten Grün- bzw. Gelb-Leuchtstoffen wie (Sr,Ca) Si2O2N2:Eu und Y3(Al,Ga)5012:Ce den Bau langlebiger warmweißer LEDs mit' Farbwiedergabeindex Ra von weniger als 80.

Ein anderes Beispiel ist das wenig stabile (Sr,Ca,Ba)S:Eu, das beispielsweise aus der EP 1 150 361 bekannt sind.

Für eine bessere Farbwiedergabe werden stabile tiefrote oder rote Leuchtstoffe benötigt, die jedoch auf Basis der o.g. Leuchtstoffe nur aufwendig und teuer herstellbar wären.

### Darstellung der Erfindung

Es ist Aufgabe der vorliegenden Erfindung, einen Leuchtstoff, der rot emittiert, bereitzustellen, der insbesondere im Emissionsbereich typischer UV-, und Blau-Grün-LEDs anregbar ist, stabil ist und einfach herzustellen ist.

Diese Aufgabe wird durch die kennzeichnenden Merkmale des Anspruchs 1 gelöst. Besonders vorteilhafte Ausgestaltungen finden sich in den abhängigen Ansprüchen.

Eine weitere Aufgabe ist die Bereitstellung einer Lichtquelle, insbesondere einer LED, mit einem derartigen Leuchtstoff.

Diese Aufgabe wird durch die kennzeichnenden Merkmale des Anspruchs 10 gelöst. Besonders vorteilhafte Ausgestaltungen finden sich in den abhängigen Ansprüchen.

Im einzelnen handelt es sich um einen rot emittierenden Leuchtstoff aus der Klasse der Oxinitridosilikate, der im wesentlichen die Struktur EA3Si2O4N2:D besitzt, wobei der Leuchtstoff als Komponente EA = Sr, Ba und/oder Ca allein oder in Kombination aufweist, wobei die aktivierende Dotierung D, die einen Teil von EA ersetzt, aus Eu besteht.

Bevorzugt ist ein Leuchtstoff, bei dem in der Darstellung von EA3Si2O4N2:D als (Sr1-x-y-zBayCaxEuz) 3Si2O4N2 der Anteil des Eu zwischen z = 0,01 und 0,10 beträgt.

Insbesondere ist EA = Sr allein oder EA = Ca allein.

Die Erfindung betrifft außerdem eine Lichtquelle mit einer primären Strahlungsquelle, die Strahlung im kurzwelligen Bereich des optischen Spektralbereichs im Wellenlängenbereich 250 bis 480 nm emittiert, wobei diese Strahlung mittels eines ersten Leuchtstoffs wie oben dargestellt ganz oder teilweise in sekundäre längerwellige Strahlung im sichtbaren Spektralbereich konvertiert wird.

Dabei dient insbesondere als primäre Strahlungsquelle eine Leuchtdiode auf Basis von InGaN oder InGaAIP oder eine Entladungslampe auf Niederdruck- oder Hochdruckbasis, insbesondere mit einer Indiumhaltigen Füllung, oder eine elektrolumineszente Lampe.

In einem bevorzugten Ausführungsbeispiel wird ein Teil der primären Strahlung weiterhin mittels weiterer Leuchtstoffe in längerwellige Strahlung konvertiert, wobei die Leuchtstoffe insbesondere geeignet gewählt und gemischt sind um weißes Licht zu erzeugen. Die Leuchtstoffe können dabei insbesondere so gewählt werden, dass die Lichtquelle eine Farbtemperatur von mindestens 2000 K, insbesondere 2700 bis 3500 K, besitzt.

Bei einer derartigen Lichtquelle lasst sich eine hohe Effizienz dadurch erreichen, dass die Emission des Chips eine Peakwellenlänge im Bereich 445 bis 475 nm hat, insbesondere 450 bis 455 nm.

Häufig liegt die Emission des Oxinitridosilikats im Bereich 595 bis 650 nm, insbesondere 600 bis 630 nm, als Peakwellenlänge.

Damit lasst sich eine Lichtquelle angeben, bei der ein Ra von mindestens 88 erzielt wird, insbesondere mehr als 90.

Erfindungsgemäß wird auch ein Verfahren zur Herstellung eines hocheffizienten Leuchtstoffs wie oben beschrieben angegeben, mit den folgenden Verfahrensschritten:
a) Bereitstellen der Ausgangsstoffe SiO₂ und/oder Si₃N₄, SrCO₃ , BaCO3, CaCO₃ sowie eines Eu-Vorläufers, insbesondere Eu203, in im wesentlichen stöchiometrischen Verhältnis;
b) Mischen der Ausgangsstoffe und Glühung unter Verwendung eines Flussmittels;
c) wobei das Glühen der Mischung bei etwa 1300 bis 1700°C, bevorzugt 1500 bis 1600°C, erfolgt.

Die erfindungsgemäßen Leuchtstoffe können auch im Zusammenhang mit anderen UV- oder Blau-Lichtquellen wie Molekularstrahlern (z.B. In-Entladungslampe), blauen OLEDs oder in Kombination mit blauen EL-Leuchtstoffen eingesetzt werden. EL steht für elektrolumineszent.

Der erfindungsgemäße Leuchtstoff ermöglicht die Herstellung von farbstabilen, effizienten LEDs bzw. LED-Modulen auf Basis einer Konversions-LED. Weitere Anwendungsbereiche sind in weißen LEDs mit guter Farbwiedergabe, Color-on-demand LEDs oder weißen OLEDs zu finden.

Der neu synthetisierte Leuchtstoff gehört der Klasse der Oxinitride oder genauer der Oxinitridosilikate an und hat die Stöchiometrie EA₃Si₂O₄N₂:Eu. Er emittiert mit hoher Effizienz im Roten. Dabei ist EA mindestens eines aus der Gruppe der Erdalkalimetalle Sr,Ba,Ca. Die Dominanzwellenlänge liegt im Falle einer Anregung bei 460 nm bei 601 nm. Dabei ist die Eu-Dotierung 2%. Sie lässt sich durch eine Erhöhung des Eu-Gehalts noch langwellig verschieben. Umgekehrt verschiebt sich die Emission bei geringem Eu-Gehalt zu kürzeren Wellenlängen hin. Die Halbwertsbreite liegt bei etwa 100 nm FWHM.

Der Leuchtstoff ist im Bereich 250 - 500 nm gut anregbar.

Der erfindungsgemäße Leuchtstoff lässt sich beispielsweise im Falle EA=Ca herstellen aus 4,5 Teilen CaO, wobei entsprechend der Dotierung dieses Material partiell durch Eu₂O₃ substituiert ist, sowie einem Teil Si₃N₄ herstellen. Alternativ geht die Herstellung über die Route mit drei Teilen CaO und einem Teil Si02. Die Ausgangsubstanzen werden gemischt und bei hohen Temperaturen in Formiergas geglüht (erste Synthese: beispielsweise bei 1500 bis 1600 °C, Formiergas).

Wesentlich für die hervorragenden Eigenschaften ist die grundsätzliche Struktur des Leuchtstoffs, ohne dass es auf eine exakte Einhaltung der Stöchiometrie ankommt. Der Leuchtstoff ist sehr strahlungsstabil, was den Einsatz in High-Brightness LEDs ermöglicht.

Das Ca kann insbesondere teilweise mit Ba oder Sr substituiert sein, so dass auch andere Wellenlängen erreichbar sind. Bevorzugt ist ein Ersatz bis zu 40 %.

Insbesondere kann dieser Leuchtstoff von einer blau emittierenden LED, vor allem vom Typ InGaN, effizient angeregt werden. Er eignet sich auch für die Anwendung bei anderen Lichtquellen, und insbesondere für die Anwendung zusammen mit anderen Leuchtstoffen zum Erzeugen von weißem Licht mit sehr hohem Ra.

Mit mehreren, insbesondere zwei bis drei, Leuchtstoffen, deren typische Quanteneffizienz deutlich über 70 % liegt, und die sehr gut im Bereich kurzwelliger UV bzw. teilweise im Bereich blauer Strahlung absorbieren, vor allem auch bei 450 bis 455 nm, wo die stärksten Chips zur Verfügung stehen, lassen sich effiziente, insbesondere auch warmweiße, LEDs mit einem Farbwiedergabeindex Ra von bis zu 97 bereitstellen. Ein typischer Ra-Wert liegt je nach gewünschter Optimierung bei -88 bis 95. Dabei ist neben dem neuen roten Oxinitridosilikat ein grüngelber Leuchtstoff hinzugefügt, beispielsweise YAG:Ce, (Lu,Y)3(Al,Ga)5012:Ce, SrSi202N2:Eu oder auch (Sr,Ba,Ca) 2SiO4:Eu. Diese emittieren im gelb-grünen Bereich mit Peakemission bei 530 bis 570 nm.

Im einzelnen wird weiterhin eine LED vorgeschlagen, die als rot emittierende Lumineszenzkonversions-LED ausgeführt ist, mit einer Primär-Strahlungsquelle, die ein Chip ist, der im blauen oder UV-Spektralbereich emittiert, und einer davor geschalteten Schicht eines Leuchtstoffs, der die Strahlung des Chips teilweise oder vollständig konvertiert, wobei der Leuchtstoff aus der Klasse der oben beschriebenen Oxinitridosilikate stammt, mit einer Dotierung von Europium.

Das Oxinitridosilikat hat die allgemeine Formel (Sr1-x-y-zCaxBayEuz)3Si204N2,-insbesondere mit x ≥ 0,3, y ≤ 0,2, z ist bevorzugt ≤ 0,1, insbesondere gilt: z = 0,01 bis 0,05.

Als Lichtquelle eignet sich insbesondere eine LED. Bevorzugt liegt die Emission des Chips so, dass er eine Peakwellenlänge im Bereich 445 bis 465 nm, insbesondere 450 bis 455 nm, hat. Damit lassen sich die höchsten Effizienzen der Primärstrahlung erzielen.

Ein weiteres Einsatzgebiet ist eine farbig emittierende LED (color-on-demand), deren Emission im roten bis tiefroten Bereich des Spektrums angesiedelt ist.

Für den Einsatz in der LED können Standardverfahren eingesetzt werden. Insbesondere ergeben sich folgende Realisierungsmöglichkeiten:

Erstens das Eindispergieren des Leuchtstoff in den LED-Verguss, beispielsweise ein Silikon oder Epoxidharz, und anschließendes Aufbringen durch beispielsweise Vergießen, Drucken, Spritzen o.ä.

Zweitens das Einbringen des Leuchtstoffs in eine sog. Pressmasse und anschließendes Spritzpressverfahren.

Drittens Methoden der chipnahen Konversion, d.h. Aufbringen der Leuchtstoffe bzw. deren Mischung auf der Wafer-Prozessings-Ebene, nach dem Vereinzeln der Chips und nach der Montage im LED-Gehäuse. Hierzu wird insbesondere auf DE-A 101 53 615 und WO-A 01/50540 verwiesen.

Die Erfindung betrifft weiterhin ein Beleuchtungssystem mit LEDs, wobei das Beleuchtungssystem weiterhin elektronische Komponenten enthält. Diese vermitteln beispielsweise die Dimmbarkeit. Eine weitere Aufgabe der Elektronik ist die Ansteuerung einzelner LEDs oder auch Gruppen von LEDs. Diese Funktionen können durch vorbekannte elektronische Elemente realisiert sein.

Bisher gibt es keinen so einfach herstellbaren rot bis tiefrot emittierenden Leuchtstoff hoher Effizienz, der gleichzeitig unempfindlich gegen äußere Einflüsse ist und außerdem durch primäre Lichtquellen, die Blau- bzw. UV emittieren, gut anregbar ist. Derartige Lichtquellen sind insbesondere UV oder blau emittierende LEDs des Typs InGaN oder auch InGaAlP, außerdem Entladungslampen, die Leuchtstoffe verwenden, wie an sich bekannt, insbesondere Hochdruckentladungslampen, die einen hohen Farbwiedergabeindex Ra aufweisen, oder die auf Indiumlampen basieren, die entweder mit Hochdruck oder Niederdruck betrieben werden können. Aufgrund seiner außerordentlichen Strahlungsstabilität eignet sich der neue Leuchtstoff aber außerdem für Entladungslampen, insbesondere für Indium-Entladungslampen und insbesondere als stabiler Leuchtstoff für Entladungslampen mit hohem Ra, beispielsweise über Ra=90.

Leuchtstoffe aus der Klasse (Sr,Ca,Ba)3Si204N2:Eu emittieren ähnlich wie Nitridosilikate im roten Spektralbereich. Sie lassen sich jedoch im Gegensatz zu diesen aus EAC03 sowie SiO2 und Si3N4 herstellen. Diese Substanzen weisen eine relativ geringe Empfindlichkeit gegen Sauerstoff und Feuchtigkeit auf und sind daher auch ohne Schutzgasatmosphäre zu verarbeiten. Außerdem sind die Carbonate als Quelle für die Erdalkaliionen deutlich billiger als die reinen Metalle oder Nitride. Daher sind die erfindungsgemäß en Leuchtstoffe sehr kostengünstig herzustellen.

Es ist im übrigen sehr erstaunlich, dass die neuartigen Leuchtstoffe rot emittieren. Im allgemeinen wird die Emission immer kurzwelliger, wenn die Verbindung zunehmend Sauerstoff enthält. So emittiert das sauerstofffreie Nitridosilikat Sr2Si5N8:Eu mit einem Verhältnis N:O=8:0 rot und das sauerstoffhaltige SrSi2O2N2:Eu mit N:O = 2:2 grün. Daher wäre zu erwarten, dass die neuartige Verbindung Sr3Si204N2:Eu mit N:O = 2:4 eher blau bis bläugrün als rot emittiert. Eine Begründung liegt vermutlich darin, dass hier die Aktivatorplätze trotz des deutlichen Überschusses an Sauerstoff trotzdem überwiegend von N³⁻-Ionen umgeben sind.

### Figuren

Im folgenden soll die Erfindung anhand mehrerer Ausführungsbeispiele näher erläutert werden. Es zeigen:
- Figur 1: das Emissionsspektrum eines erfindungsgemäßen Leuchtstoffs;
- Figur 2: das Reflexionsspektrum dieses Leuchtstoffs;
- Figur 3: den Aufbau einer Konversions-LED;
- Figur 4: eine Niederdrucklampe mit Indium-Füllung unter Verwendung eines Orthosilikats.

### Beschreibung der Zeichnungen

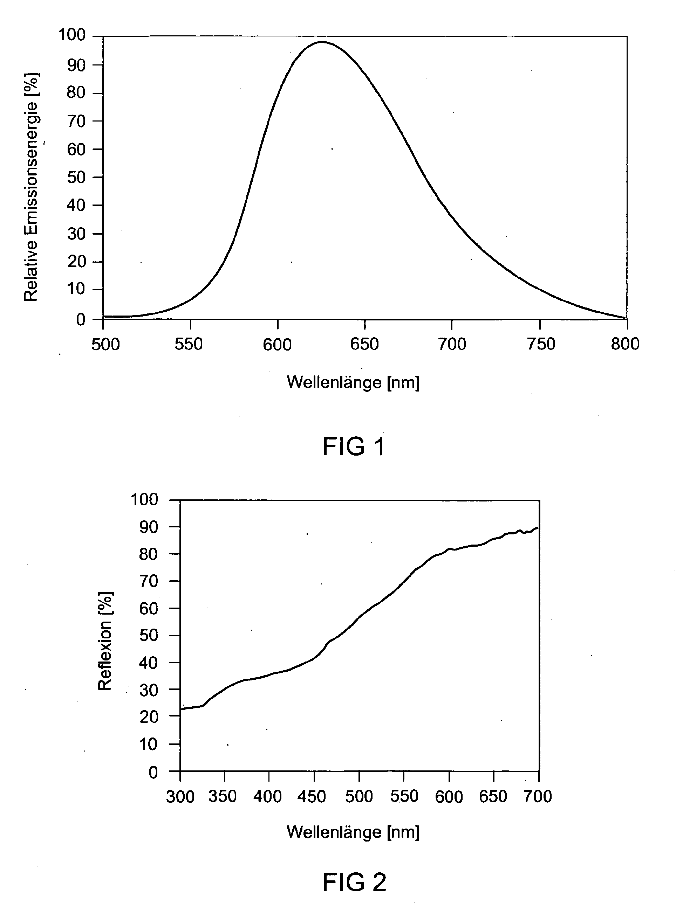

Ein konkretes Beispiel für den erfindungsgemäßen Leuchtstoff ist in Figur 1 gezeigt. Es zeigt die Emission des Leuchtstoffs Sr3Si2O4N2:Eu mit einem Eu-Anteil von 2 mol-% der von Sr besetzten Gitterplätze. Das Emissionsmaximum des reinen Leuchtstoffs (Peak) liegt bei 620 nm. Die Anregung erfolgte bei 460 nm. Die FWHM ist 99 nm. Die dominante Wellenlänge ist 601 nm. Die Quanteneffizienz liegt bei gut 80 %. Eine alternaive Darstellung dieses Leuchtstoffs ist Sr2, 94Eu0, 06SiO4N2.

In Figur 2 ist das Reflexions-Spektrum dieses Leuchtstoffs gezeigt.

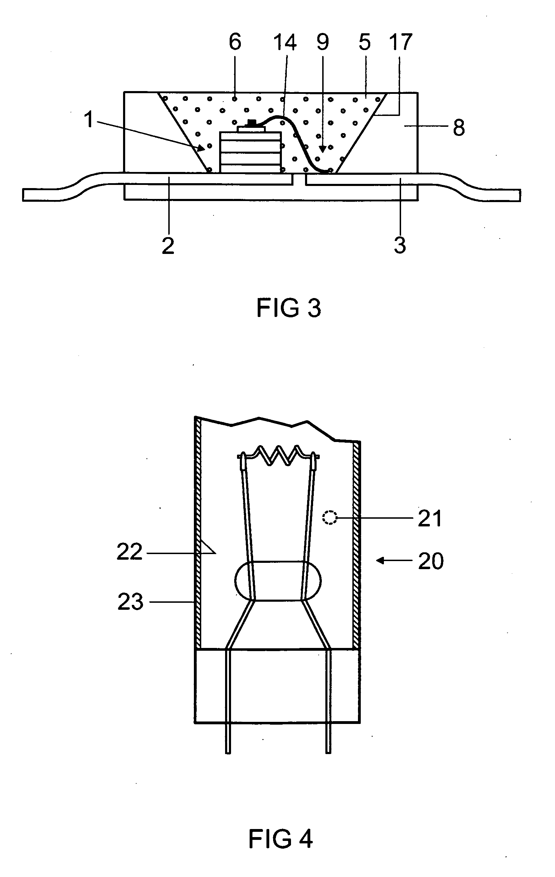

Der Aufbau einer Lichtquelle für rotes Licht ist in Figur 3 explizit gezeigt. Die Lichtquelle ist ein Halbleiterbauelement mit einem Chip 1 des Typs InGaN mit einer Peakemissionswellenlänge von 440 bis 470 nm, beispielsweise 460 nm, das in ein lichtundurchlässiges Grundgehäuse 8 im Bereich einer Ausnehmung 9 eingebettet ist. Der Chip 1 ist über einen Bonddraht 14 mit einem ersten Anschluss 3 und direkt mit einem zweiten elektrischen Anschluss 2 verbunden. Die Ausnehmung 9 ist mit einer Vergussmasse 5 gefüllt, die als Hauptbestandteile ein Epoxidgießharz (80 bis 90 Ges.-%) und Leuchtstoffpigmente 6 eines Leuchtstoffe (weniger als 20 Ges.-%) enthält. Der Leuchtstoff ist das als erstes Ausführungsbeispiel vorgestellte Sr-Oxinitridosilikat mit 2 % Eu. Die Ausnehmung 9 hat eine Wand 17, die als Reflektor für die Primär- und Sekundärstrahlung vom Chip 1 bzw. den Pigmenten 6 dient. Die dominante Wellenlänge bei 581 nm erfüllt gerade die Spezifikation für das Gelb in Ampelanlagen.

Im allgemeinen wird die Effizienz und der Farbwiedergabeindex Ra durch die Höhe der Dotierung mit Eu angepasst, bevorzugt ist ein Wert für Eu von 1 bis 5 mol-% des A.

Ein anderes Beispiel ist Ca3N2Si204:Eu, das ähnliche Eigenschaften wie Sr3N2Si204:Eu zeigt.

Bei einer weißen LED mit drei Leuchtstoffen wird neben dem Sr-Oxinitridosilikat als ein grün emittierender Leuchtstoff SrSi202N2:Eu verwendet. Die Kombination der blauen Primär- und roten, und gelbgrünen Sekundärstrahlung mischt sich zu warmweiß mit hohem Ra von 88 bis 97. dabei genügen hier zwei Leuchtstoffe im Gegensatz zum Stand der Technik, der dafür drei Leuchtstoffe benötigte.

Figur 4 zeigt eine Niederdruck-Entladungslampe 20 mit einer quecksilberfreien Gasfüllung 21 (schematisiert), die eine Indiumverbindung und ein Puffergas analog WO 02/10374 enthält, wobei eine Schicht 22 aus Oxinitridosilikat Sr3N2Si2O4:Eu innen am Kolben 23 angebracht ist. Der ganz besondere Vorteil bei dieser Anordnung ist, dass dieses Orthosilikat ideal der Indium-Strahlung angepasst ist, weil diese wesentliche Anteile sowohl im UV als auch im blauen Spektralbereich hat, die von diesem Orthosilikat beide gleichermaßen gut absorbiert werden, was ihn bei dieser Verwendung gegen die bisher bekannten Leuchtstoffe überlegen macht. Diese bekannten Leuchtstoffe absorbieren nennenswert entweder nur die UV-Strahlung oder die blaue Strahlung des Indiums, so dass die erfindungsgemäße Indium-Lampe eine deutlich höhere Effizienz zeigt. Diese Aussage gilt auch für eine Indium-Lampe auf Hochdruck-Basis wie an sich aus US 4 810 938 bekannt.

## Patentansprüche

1. Rot emittierender Leuchtstoff aus der Klasse der Oxinitridosilikate, der im wesentlichen die Struktur EA3Si2O4N2:D besitzt, **dadurch gekennzeichnet, dass** der Leuchtstoff als Komponente EA = Sr, Ba und/oder Ca allein oder in Kombination aufweist, wobei die aktivierende Dotierung D, die einen Teil von EA ersetzt, aus Eu besteht.

2. Leuchtstoff nach Anspruch 1, **dadurch gekennzeichnet, dass** in der Darstellung von EA3Si204N2:D als (Sr1-x-y-zBayCaxEuz)3Si2O4N2 der Anteil des Eu zwischen z = 0,01 und 0,10 beträgt.

3. Leuchtstoff nach Anspruch 1, **dadurch gekennzeichnet, dass** EA = Sr allein ist.

4. Leuchtstoff nach Anspruch 1, **dadurch gekennzeichnet, dass** EA = Ca allein ist.

5. Lichtquelle mit einer primären Strahlungsquelle, die Strahlung im kurzwelligen Bereich des optischen Spektralbereichs im Wellenlängenbereich 250 bis 480 nm emittiert, wobei diese Strahlung mittels eines ersten Leuchtstoffs nach einem der vorhergehenden Ansprüche ganz oder teilweise in sekundäre längerwellige Strahlung im sichtbaren Spektralbereich konvertiert wird.

6. Lichtquelle nach Anspruch 5, **dadurch gekennzeichnet, dass** als primäre Strahlungsquelle eine Leuchtdiode auf Basis von InGaN oder InGaA1P oder eine Entladungslampe auf Niederdruck- oder Hochdruckbasis, insbesondere mit einer Indiumhaltigen Füllung, oder eine elektrolumineszente Lampe verwendet wird.

7. Lichtquelle nach Anspruch 5, **dadurch gekennzeichnet, dass** ein Teil der primären Strahlung weiterhin mittels weiterer Leuchtstoffe in längerwellige Strahlung konvertiert wird, wobei die Leuchtstoffe insbesondere geeignet gewählt und gemischt sind um weißes Licht zu erzeugen.

8. Lichtquelle nach Anspruch 7, **dadurch gekennzeichnet, dass** die Lichtquelle eine Farbtemperatur von mindestens 2000 K, insbesondere 2700 bis 3500 K, besitzt.

9. Lichtquelle nach Anspruch 5, **dadurch gekennzeichnet, dass** die Emission der Primär-Strahlungsquelle, die ein Chip ist, eine Peakwellenlänge im Bereich 445 bis 475 nm hat, insbesondere 450 bis 455 nm.

10. Lichtquelle nach Anspruch 5, **dadurch gekennzeichnet, dass** die Emission des Oxinitridosilikats eine Peakwellenlänge im Bereich 595 bis 650 nm, insbesondere 600 bis 630 nm, hat.

11. Lichtquelle nach Anspruch 5, **dadurch gekennzeichnet, dass** ein Ra von mindestens 88 erzielt wird, insbesondere mehr als 90.

12. Verfahren zur Herstellung eines hocheffizienten Leuchtstoffs gemäß Anspruch 1, **gekennzeichnet durch** die folgenden Verfahrensschritte:
a) Bereitstellen der Ausgangsstoffe SiO₂ und/oder Si₃N₄, SrCO₃ BaC03, CaCO₃ sowie eines Eu-Vorläufers, insbesondere Eu203, in im wesentlichen stöchiometrischen Verhältnis;
b) Mischen der Ausgangsstoffe und Glühung unter Verwendung eines Flussmittels;
c) wobei das Glühen der Mischung bei etwa 1300 bis 1700°C, bevorzugt 1500 bis 1600°C, erfolgt.

## Claims

1. Red-emitting luminescent substance from the class of the oxynitridosilicates, which substantially has the structure EA3Si2O4N2:D, **characterized in that** the luminescent substance has as component EA = Sr, Ba and/or Ca alone or in combination, wherein the activating doping D, which replaces part of EA, consists of Eu.

2. Luminescent substance according to Claim 1, **characterized in that** in the representation of EA3Si2O4N2:D as (Srl-x-y-zBayCaxEuz)3Si204N2, the proportion of Eu is between z = 0.01 and 0.10.

3. Luminescent substance according to Claim 1, **characterized in that** EA = Sr alone.

4. Luminescent substance according to Claim 1, **characterized in that** EA = Ca alone.

5. Light source having a primary radiation source, which emits radiation in the short-wave range of the optical spectral range in the wavelength range from 250 to 480 nm, wherein this radiation is wholly or partly converted into secondary radiation with a longer wavelength in the visible spectral range by means of a first luminescent substance according to any of the preceding claims.

6. Light source according to Claim 5, **characterized in that** the primary radiation source used is a light-emitting diode based on InGaN or InGaAlP or a discharge lamp based on low pressure or high pressure, in particular with an indium-containing fill, or an electroluminescent lamp.

7. Light source according to Claim 5, **characterized in that** part of the primary radiation is furthermore converted into radiation with a longer wavelength by means of further luminescent substances, wherein the luminescent substances are in particular selected and mixed appropriately so as to generate white light.

8. Light source according to Claim 7, **characterized in that** the light source has a color temperature of at least 2000 K, in particular 2700 to 3500 K.

9. Light source according to Claim 5, **characterized in that** the emission of the primary radiation source, which is a chip, has a peak wavelength in the range from 445 to 475 nm, in particular 450 to 455 nm.

10. Light source according to Claim 5, **characterized in that** the emission of the oxynitridosilicate has a peak wavelength in the range from 595 to 650 nm, in particular 600 to 630 nm.

11. Light source according to Claim 5, **characterized in that** an Ra of at least 88 is obtained, in particular more than 90.

12. Process for producing a high-efficiency luminescent substance according to Claim 1, **characterized by** the following process steps:
a) providing the starting materials SiO₂ and/or Si₃N₄, SrCO₃, BaC03, CaCO₃ and an Eu precursor, in particular Eu203, in a substantially stoichiometric ratio;
b) mixing the starting materials and annealing using a flux;
c) wherein the annealing of the mixture is carried out at approximately 1300 to 1700°C, preferably 1500 to 1600°C.

## Revendications

1. Substance luminescente émettant dans le rouge de la classe des oxynitridosilicates, qui a sensiblement la structure EA3Si2O4N2:D, **caractérisée en ce que** la substance luminescente a comme constituant EA = Sr, Ba et/ou Ca, seul ou en combinaison, le dopage D activant, qui remplace une partie de EA, étant en Eu.

2. Substance luminescente suivant la revendication 1, **caractérisée en ce que** dans la représentation de EA3Si2O4N2:D, en tant que (Sr1-x-y-zBayCaxEuz) 3Si2O4N2 la proportion de Eu est comprise entre z = 0,01 et 0,10.

3. Substance luminescente suivant la revendication 1, **caractérisée en ce que** EA = Sr seul.

4. Substance luminescence suivant la revendication 1, **caractérisée en ce que** EA = Ca seul.

5. Source lumineuse ayant une source de rayonnement primaire qui émet du rayonnement dans le domaine des courtes longueurs d'onde du spectre optique, dans le domaine des longueurs d'onde de 250 à 480 nm, ce rayonnement étant transformé au moyen d'une première substance luminescente suivant l'une des revendications précédentes, en tout ou partie, en des rayonnements secondaires de plus grandes longueurs d'onde dans le domaine visible du spectre.

6. Source lumineuse suivant la revendication 5, **caractérisée en ce qu'**il est utilisé, comme source de rayonnement primaire, une diode électroluminescente à base d'InGaN ou d'InGaAIP ou une lampe à décharge à base de basse pression et de haute pression, ayant notamment un remplissage contenant de l'indium, ou une lampe électroluminescente.

7. Source lumineuse suivant la revendication 5, **caractérisée en qu'**une partie du rayonnement primaire est transformée, en outre, au moyen d'autres substances luminescentes, en du rayonnement de plus grandes longueurs d'onde, les substances luminescente étant choisies et mélangées notamment de manière appropriée pour produire de la lumière blanche.

8. Source lumineuse suivant la revendication 7, **caractérisée en**tre la source lumineuse à une température de couleur d'au moins 2000 K, notamment comprise entre 2700 et 3500 K.

9. Source lumineuse suivant la revendication 5, **caractérisée en ce que** l'émission de la source de rayonnement primaire, qui est une puce, a une longueur d'onde de crête comprise entre 445 et 475 nm, notamment entre 450 et 455 nm.

10. Source lumineuse suivant la revendication 5, **caractérisée en ce que** l'émission de l'oxinitridosilicate a une longueur d'onde de crête comprise entre 595 et 650 nm, notamment entre 600 et 630 nm.

11. Source lumineuse suivant la revendication 5, **caractérisée en ce qu'**il est obtenu un Ra d'au moins 88, notamment supérieur à 90.

12. Procédé de production d'une substance luminescente très efficace, suivant la revendication 1, **caractérisé par** le stade de procédés suivants :
a) on se procure les substances de départ SiO₂ et/ou Si₃N₄, SrCO₃, BaCO₃, CaCO₃, ainsi qu'un précurseur de Eu, notamment Eu203, en un rapport sensiblement stoechiométrique ;
b) on mélange les substances de départ et on les calcine en utilisant un flux ;
c) on effectue la calcination du mélange entre environ 1300 à 1700°C, de préférence entre 1500 et 1600°C.
